# DEMANDE DE BREVET EUROPEEN

(11) **EP 2 037 287 A1**
(43) Date de publication de la demande: **18.03.2009**
(21) Numéro de dépôt: 08163566.6
(22) Date de dépôt: 03.09.2008
(51) Int. Cl.: G01R 31/00, G01R 31/04

(54) **Procédé de détection d'une défaillance sur un système d'alimentation d'une charge électrique**

(30) Priorité: 11.09.2007 FR 0757474
(71) Demandeur: Peugeot Citroën Automobiles SA, 78943 Vélizy-Villacoublay Cedex (FR)
(72) Inventeur: Cathary, Pierre, 78500 Sartrouville (FR); Serezat, Laurent, 91410 Corbreuse (FR)
(74) Mandataire: Vigand, Régis Louis Michel

(57) **Abrégé**

La présente invention a pour objet un procédé de détection d'une défaillance sur un système d'alimentation d'une charge d'un véhicule automobile par une source d'alimentation via un réseau électrique.

La détection est réalisée suivant les étapes suivantes :
- L'absence de défaillance sur le réseau électrique (C'2) est indiquée par l'émission d'une première et unique impulsion (P1) de courant lors de la connexion entre la source et la charge,
- La présence d'une défaillance localisée sur le réseau électrique ou sur la charge (C'1) est indiquée par l'absence d'émission de la première impulsion de courant,
- La présence d'une défaillance sur la charge survenue après la connexion entre la source d'alimentation et la charge (C'3) est indiquée par l'émission d'une deuxième impulsion (P3) de courant suivant la première impulsion (P2).

L'invention s'applique plus particulièrement aux systèmes d'éclairage comportant des diodes électroluminescentes.

## Description

La présente invention a pour objet un procédé de détection d'une défaillance sur un système d'alimentation d'une charge électrique d'un véhicule automobile par une source d'alimentation via un réseau électrique. L'invention trouve une application particulièrement intéressante lorsque la charge électrique est formée par au moins une diode électroluminescente LED («Light Emitting Diode » en anglais) et lorsque ledit réseau électrique est formé par un faisceau de conducteurs électriques du véhicule. Les diodes LEDS sont utilisées dans différents systèmes d'éclairage du véhicule (des feux clignotants jusqu'aux feux de route)

On connaît des procédés de détection de défaillances d'une charge électrique telle qu'un module d'éclairage dans un véhicule automobile qui consiste à détecter une modification de la résistance de charge en mesurant directement une variation du courant dans la charge (et/ou de la tension aux bornes de la charge). Ce type de diagnostic est efficace dès lors que la consommation nécessaire à la charge est importante. Pour des charges de plus faible consommation la variation des caractéristiques est plus difficilement perceptible.

On connaît également des procédés de détection permettant de résoudre le problème mentionné ci-dessus en utilisant une source de courant pilotée par la charge électrique. Le principe consiste à augmenter le courant débité en fonctionnement normal de façon à pouvoir déceler une éventuelle défaillance même dans le cas d'une charge consommant peu. Ce procédé est plus particulièrement adapté aux charges telles que des modules d'éclairage comportant des diodes électroluminescentes LEDS.

La mise en oeuvre d'une telle solution pose cependant également certaines difficultés.

En effet, la solution utilisée implique par principe le débit d'un courant supplémentaire en mode de fonctionnement normal et entraîne donc des pertes énergétiques importantes.

Par ailleurs, la source de courant supplémentaire doit être dimensionnée en fonction de la charge concernée et dépend donc fortement de cette dernière.

Dans ce contexte, la présente invention vise à fournir un procédé de détection d'une défaillance sur un système d'alimentation d'une charge électrique d'un véhicule automobile par une source d'alimentation via un réseau électrique permettant de s'affranchir des problèmes précités en réduisant notablement les pertes et en étant beaucoup moins dépendant de la charge à piloter.

A cette fin, l'invention propose un procédé de détection d'une défaillance sur un système d'alimentation d'une charge électrique d'un véhicule automobile par une source d'alimentation via un réseau électrique caractérisé en ce que ladite détection est réalisée suivant les étapes suivantes :
- L'absence de défaillance sur ledit réseau électrique est indiquée par l'émission d'une première et unique impulsion de courant lors de la connexion entre ladite source d'alimentation et ladite charge,
- La présence d'une défaillance localisée sur ledit réseau électrique ou sur ladite charge est indiquée par l'absence d'émission de ladite première impulsion de courant lors de la connexion entre ladite source d'alimentation et ladite charge,
- La présence d'une défaillance sur ladite charge survenue après la connexion entre ladite source d'alimentation et ladite charge est indiquée par l'émission d'une deuxième impulsion de courant suivant la première impulsion.

De façon générale, on entend par impulsion une augmentation brusque du signal et un retour à son état initial.

Le procédé selon l'invention peut également présenter une ou plusieurs des caractéristiques ci-dessous, considérées individuellement ou selon toutes les combinaisons techniquement possibles.

Selon un mode de réalisation particulièrement avantageux, ladite charge électrique est une lampe à LED «Light Emitting Diode» et ledit réseau électrique est formé par un faisceau de conducteurs électrique.

Préférentiellement, la durée des dites première et deuxième impulsions est inférieure ou égale à 200 ms, de préférence de l'ordre de 100 ms.

Selon un mode de réalisation, ladite détection est réalisée suivant les étapes suivantes :
- Ladite absence d'émission de ladite première impulsion de courant lors de la connexion entre ladite source d'alimentation et ladite charge indique la présence d'une défaillance localisée sur ledit réseau électrique,
- La présence d'une défaillance sur ladite charge est indiquée par l'émission d'une deuxième impulsion de courant suivant la première impulsion.

La présente invention a également pour objet un premier circuit pour la mise en oeuvre du procédé selon l'invention caractérisé en ce qu'il comporte :
- une première entrée apte à recevoir un signal d'échelon de tension, dit signal de puissance, correspondant à la tension de mise en connexion entre ladite source d'alimentation et ladite charge,
- une deuxième entrée apte à recevoir un signal d'échelon de tension, dit signal de diagnostic, correspondant à la présence d'une défaillance sur ladite charge électrique,
- des moyens pour transformer ledit signal de puissance en une première impulsion de tension,
- des moyens pour transformer ledit signal de diagnostic en une deuxième impulsion de tension,
- des moyens pour recevoir lesdites première et deuxième impulsions de tension et formant un opérateur « ou exclusif » entre lesdites première et deuxième impulsions,
- des moyens de commutation de courant commandé en tension, la fermeture des moyens de commutation de courant générant lesdites impulsions de courant nécessaires à la détection de défaillance, la présence des dites impulsions de courant étant conditionnées par la sortie dudit opérateur « ou exclusif ».

La présente invention a également pour objet un deuxième circuit pour la mise en oeuvre du procédé selon l'invention caractérisé en ce qu'il comporte :
- une première entrée apte à recevoir un signal d'échelon de tension, dit signal de puissance, correspondant à la tension de mise en connexion entre ladite source d'alimentation et ladite charge,
- une deuxième entrée apte à recevoir un signal d'échelon de tension, dit signal de diagnostic, correspondant à la présence d'une défaillance sur ladite charge électrique,
- des moyens pour transformer ledit signal de puissance en une première impulsion de tension,
- des moyens pour transformer ledit signal de diagnostic en une deuxième impulsion de tension,
- des moyens de commutation de courant commandé par lesdites première et deuxième impulsions de courant, la fermeture dudit interrupteur de courant générant lesdites impulsions de courant nécessaires à la détection de défaillance,
- des moyens pour empêcher une superposition des dites première et deuxième impulsions de courant.

Avantageusement, lesdits moyens pour empêcher une superposition des dites première et deuxième impulsions sont formés par un circuit RC.

Chacun des premier ou deuxième circuits selon l'invention peut également présenter une ou plusieurs des caractéristiques ci-dessous, considérées individuellement ou selon toutes les combinaisons techniquement possibles :
Avantageusement, lesdits moyens pour transformer ledit signal de puissance en une première impulsion de tension comportent un premier filtre passe bas RC, un premier filtre passe haut CR et une première diode et lesdits moyens pour transformer ledit signal de diagnostic en une seconde impulsion de tension comportent un second filtre passe bas RC, un second filtre passe haut CR et une seconde diode.

Selon un mode de réalisation préférentiel, lesdits moyens de commutation de courant comportent un premier et un second interrupteur de courant reliés en série avec au moins une résistance et une source d'alimentation, ledit premier interrupteur étant commandé par la cathode commune des dites première et seconde diodes, et lesdits moyens pour recevoir lesdites première et deuxième impulsions de tension et formant un opérateur «ou exclusif» entre lesdites première et deuxième impulsions comportent:
- un troisième interrupteur commandé par la sortie dudit premier filtre passe haut CR,
- un quatrième interrupteur commandé par la sortie dudit second filtre passe haut CR,

Lesdits second, troisième et quatrième interrupteurs de courant étant agencés de sorte que l'ouverture desdits troisième ou quatrième interrupteurs de courant entraîne la fermeture dudit deuxième interrupteur de courant.

Avantageusement, au moins un desdits premier à quatrième interrupteurs est un transistor MOSFET.

D'autres caractéristiques et avantages de l'invention ressortiront clairement de la description qui en est donnée ci-dessous, à titre indicatif et nullement limitatif, en référence aux figures annexées, parmi lesquelles:
- la figure 1 est une représentation schématique d'un système d'alimentation pour la mise en oeuvre du procédé selon l'invention ;
- la figure 2 représente un exemple de valeurs typiques d'impulsions engendrées lors du procédé selon l'invention ;
- la figure 3 est une représentation schématique de trois chronogrammes engendrés selon un premier mode de réalisation de l'invention ;
- la figure 4 est une représentation schématique de trois chronogrammes engendrés selon un deuxième mode de réalisation de l'invention ;
- la figure 5 représente un schéma simplifié d'un circuit pour la mise en oeuvre du procédé selon le deuxième mode de réalisation illustré en figure 4 ;
- La figure 6 représente un circuit pour la mise en oeuvre du procédé selon le deuxième mode de réalisation illustré en figure 4 ;
- La figure 7 représente un circuit pour la mise en oeuvre du procédé selon le premier mode de réalisation illustré en figure 3 ;
- La figure 8 représente un circuit pour la génération du signal de diagnostic utilisé comme entrée des circuits représentés sur les figures 6 ou 7.

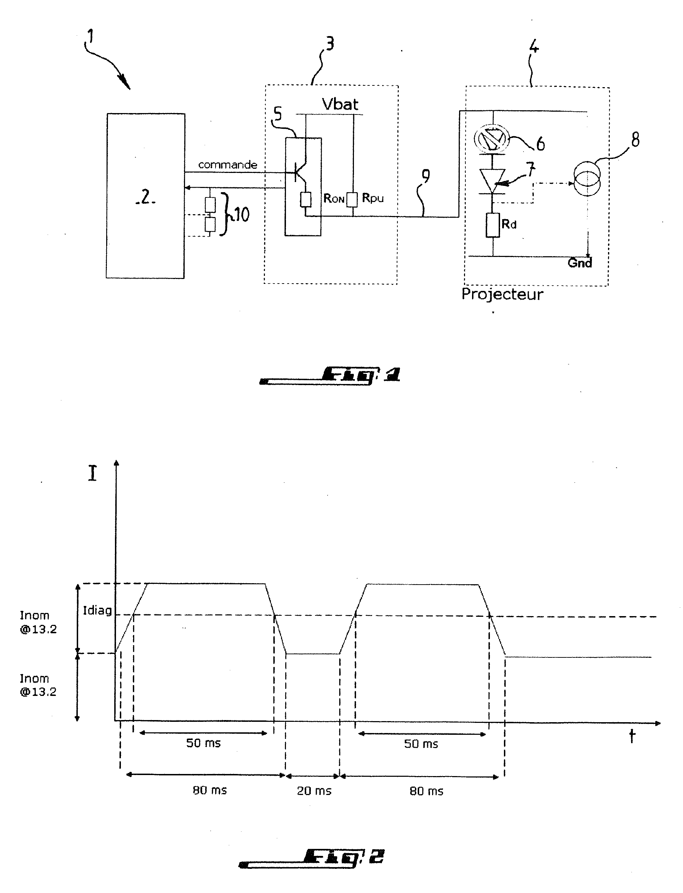

La figure 1 est une représentation schématique d'un système 1 d'alimentation pour la mise en oeuvre du procédé selon l'invention.

Le procédé selon l'invention est illustré dans le cas de charges qui sont des diodes LED ; on notera toutefois que ce procédé s'applique sur tout type de charge capacitive ou résistive.

Le système d'alimentation 1 comporte :
- une source d'alimentation électrique Vbat (typiquement la tension de la batterie du véhicule égale à 12V) ;
- un boitier de servitude 2,
- un module intelligent 3 comportant :
   o un interrupteur commandé intelligent 5 du type «smart transistor»,
   o une résistance de tirage Rpu,
- un module d'éclairage 4 comportant :
   o deux LEDS 6 et 7, la diode 6 étant défaillante,
   o une résistance Rd,
   o une source de courant 8 pour la mise en oeuvre du procédé selon l'invention,
- un réseau d'alimentation électrique 9 formé par un faisceau de conducteurs électriques,
- un capteur de courant 10.

L'interrupteur 5 et la résistance Rpu sont montés en parallèle entre la source de tension Vbat et le réseau électrique 9 qui est raccordé à son autre extrémité à une borne de la diode 6 défaillante elle-même montée en série avec la diode 7, la résistance Rd et la masse.

La résistance Ron schématise la résistance de l'interrupteur 5 lorsque ce dernier est fermé ; cette résistance Ron présente une valeur bien inférieure à la valeur de la résistance Rpu.

Le boitier de servitude 2 assure la commande de l'interrupteur 5.

La fermeture de l'interrupteur 5 entraîne la mise en court-circuit de la résistance Rpu et l'alimentation des LEDS 6 et 7 par la source de tension Vbat via le réseau 9 pour un fonctionnement normal des LEDS.

L'ouverture de l'interrupteur 5 entraîne la connexion des diodes 6 et 7 à la résistance Rpu via le réseau 9. La résistance Rpu est une résistance de tirage (« Pull up » en anglais) dont la valeur est sélectionnée pour que l'alimentation des diodes 6 et 7 via cette résistance ne permette pas aux diodes de s'allumer. La fonction de cette résistance Rpu est de détecter une défaillance des diodes 6 et 7 lorsque ces dernières sont éteintes : ce diagnostic (non représenté ici) des diodes en état hors de fonctionnement est réalisé par une mesure de tension transmise au module de servitude 2.

La résistance Rd en série avec les diodes 6 et 7 est une résistance de protection qui permet de protéger les LEDS d'éventuelles surtensions.

Le module d'éclairage 4 comporte en outre une source de courant 8 permettant la mise en oeuvre du procédé selon l'invention. Le principe de ce procédé (qui sera décrit plus en détails dans ce qui suit) est de ne déclencher la commande de cette source de courant qu'en cas de défaillance d'une LED contrairement aux procédés connus qui consiste à utiliser une source de courant fonctionnant en permanence et donc à augmenter en permanence le courant débité de façon à pouvoir déceler une éventuelle défaillance (on a le courant débité par la charge plus le courant débité par la source). Le procédé selon l'invention entraîne donc une surconsommation ponctuelle et présente l'avantage de diminuer fortement la consommation du module d'éclairage 4 et d'être peu dépendant vis-à-vis de la charge à piloter.

Le courant débité est détecté par le module de servitude 2 via un capteur 10, de courant formé par exemple par deux résistances en série qui peut être soit intégré à l'interrupteur intelligent 5 soit intégré au module de servitude 2.

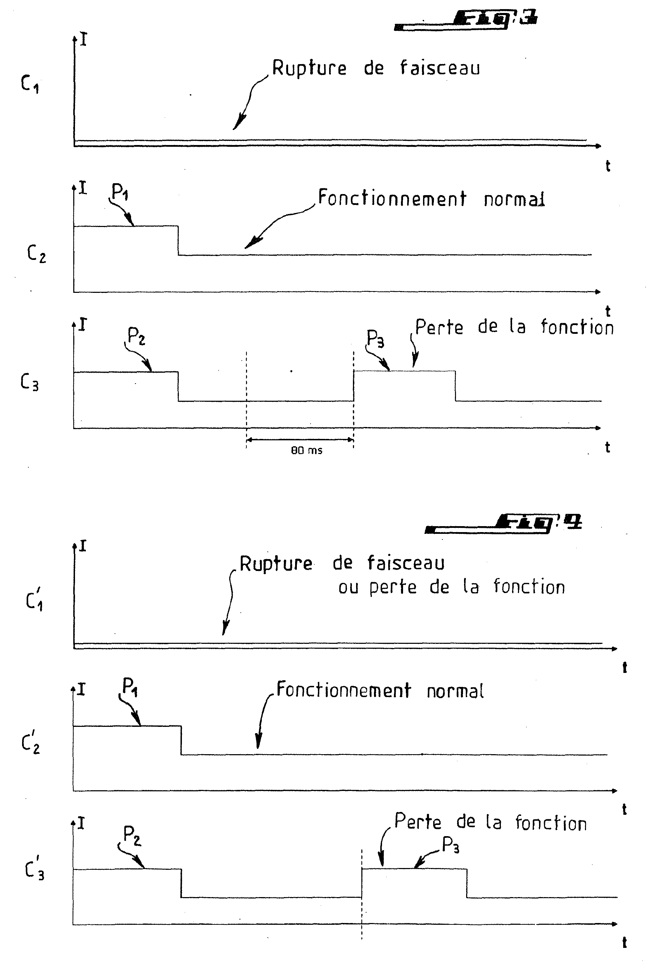

Le procédé selon l'invention sera mieux compris en référence à la figure 3 qui est une représentation schématique de trois chronogrammes engendrés selon un premier mode de réalisation du procédé selon l'invention.

Les trois chronogrammes représentent chacun une configuration du courant généré par la source 8 en fonction de l'état défaillant ou non du système d'alimentation 1.

On notera que, lors d'une rupture de faisceau, la source de courant 8 ne peut être activée ; par conséquent, le procédé selon l'invention inclut une étape de génération d'une première impulsion à chaque allumage de la fonction (ici la fonction d'allumage du module de projecteur 4), c'est-à-dire à chaque mise sous alimentation de la charge.

Ce mode de fonctionnement normal est représenté sur le chronogramme C2 pour lequel une seule et unique impulsion P1 est générée.

Lorsque le module de servitude 2 ne détecte pas d'impulsion à l'allumage, comme représenté sur le chronogramme C1, on en déduit une défaillance correspondant à une rupture de faisceau.

Lorsque le module de servitude 2 détecte une impulsion P2 suivie d'une impulsion P3, le module 2 en déduit une défaillance liée à au moins une des LEDS du module 4 d'éclairage (perte de la fonction éclairage).

On notera que si la défaillance du module 4 d'éclairage a lieu à l'allumage, il y a un risque de superposition des deux impulsions (impulsion correspondant au fonctionnement normal et impulsion liée au dysfonctionnement du module 4 d'éclairage). Une manière de régler ce problème consiste à introduire un décalage (par exemple de l'ordre de 80 ms) entre l'instant de la défaillance du module 4 d'éclairage et le déclenchement de la seconde impulsion P3. Dès lors, le risque de confusion est évité sur le chronogramme C2.

Dans le cas où l'introduction d'un retard n'est pas envisageable, une autre solution est illustrée sur la figure 4.

Dans ce cas, on n'effectue aucune surconsommation (i.e. génération d'impulsion de courant) dans le cas d'une superposition, c'est-à-dire dans le cas d'une défaillance intervenant pendant la génération de la première impulsion liée au fonctionnement normal.

Dès lors, dans le cas du chronogramme C'1, le module de servitude 2 en déduit soit la présence d'une rupture de faisceau soit une perte de la fonction d'éclairage sans qu'il soit possible de distinguer le type de défaillance.

Le chronogramme C'2 est identique au chronogramme C2.

Le chronogramme C'3 indique une défaillance de la fonction d'éclairage intervenue après la génération de la première impulsion de courant.

Des ordres de grandeurs concernant les impulsions de courant générées sont données en figure 2. A titre d'exemple, on constate que la durée d'une impulsion est de l'ordre de 80 ms, l'impulsion représentant sensiblement le double du courant nominal débité normalement dans la charge.

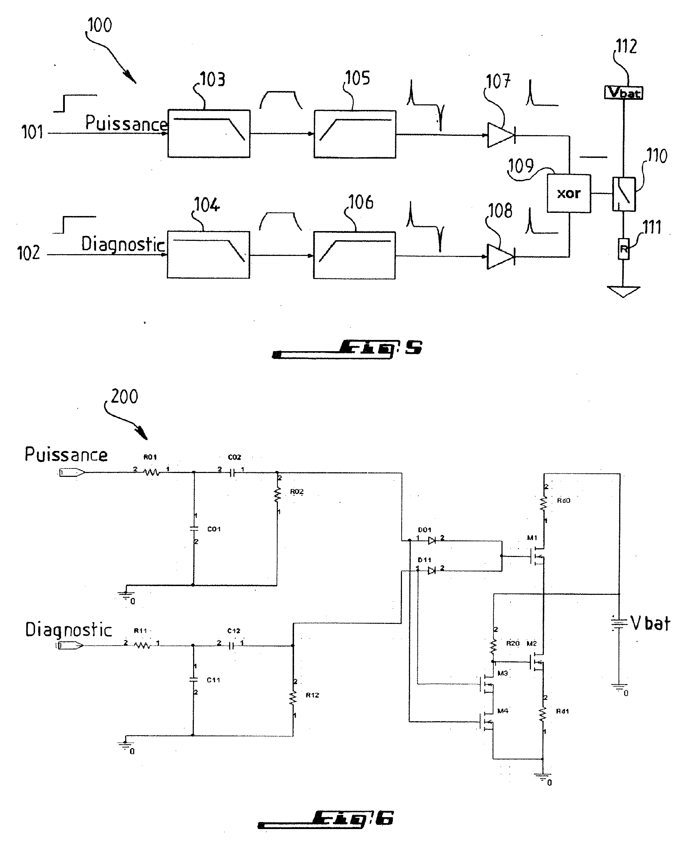

La figure 5 représente un schéma simplifié d'un circuit 100 pour la mise en oeuvre du procédé selon le deuxième mode de réalisation illustré en figure 4 (i.e. cas où l'absence d'impulsion indique soit une perte de fonction soit une rupture de faisceau sans possibilité de distinction entre les deux types de défaillance).

Le circuit 100 comporte :
- deux entrées 101 et 102 aptes à recevoir respectivement un signal de puissance et un signal de diagnostic,
- deux filtres passe-bas 103 et 104, chacun d'entre eux étant respectivement relié à l'entrée 101 et à l'entrée 102,
- deux filtres passe-haut 105 et 106 ayant chacun une entrée reliée respectivement à la sortie du filtre passe-bas 103 et à la sortie du filtre passe-bas 104,
- deux diodes 107 et 108 ayant chacune son anode reliée respectivement à la sortie du filtre passe-haut 105 et à la sortie du filtre passe-haut 106,
- un module 109 formant un opérateur «ou exclusif»,
- des moyens de commutation 110 commandé en tension,
- une résistance 111,
- la source d'alimentation Vbat.

Comme nous le verrons en référence à la figure 6, les moyens de commutation 110 et le module 109 peuvent être formés par une série de transistors.

Le signal de puissance est un échelon de tension dont le front montant correspond à l'allumage (c'est à dire à l'apparition de la tension de mise en connexion entre la tension Vbat et la ou les LED(S)).

Le signal de diagnostic est un échelon de tension dont le front montant correspond à la présence d'une défaillance sur au moins une des LEDS.

Chacun des filtres passe-bas 103 et 104 permet de diminuer sensiblement le temps de montée du signal d'entrée sur chacun des filtres passe-haut 105 et 106. Ces deux filtres passe-bas peuvent également être enlevés selon le temps de montée de leur signal d'entrée.

Chacun des filtres passe-haut 105 et 106 permet de réaliser l'intégration du signal reçu en entrée afin de ne réagir que sur les fronts de celui-ci.

Chacune des diodes 107 et 108 permet d'éliminer la composante négative du signal lors du front descendant.

A l'allumage et sans défaillance du faisceau et des LEDS, on aura uniquement un échelon de tension sur l'entrée 101 correspondant au signal de puissance qui va entraîner une impulsion de tension après la diode 107 ; du fait de l'absence de défaillance des LEDS, il n'y aura pas d'échelon de tension de diagnostic sur l'entrée 102. En conséquence, le module « ou exclusif » 109 va produire une impulsion de tension qui va fermer les moyens de commutation 110 le temps de l'impulsion ; la fermeture des moyens de commutation 110 va générer une impulsion de courant dans la résistance 111.

Si aucune défaillance d'une LED ne se produit après l'allumage de la fonction, on a donc bien une seule impulsion de courant correspondant au chronogramme C'2 de la figure 4.

Si une défaillance d'une LED se produit après l'allumage de la fonction, un échelon de tension est injecté sur l'entrée 102 ; de la même manière que ci-dessus, on va obtenir une impulsion de tension après la diode 108. Cette impulsion de tension se produisant après la première impulsion de tension, le module «ou exclusif» 109 va produire une nouvelle impulsion de tension qui va fermer à nouveau les moyens de commutation 110 le temps de l'impulsion ; la fermeture des moyens de commutation 110 va générer une deuxième impulsion de courant dans la résistance 111 : ce cas est illustré par le chronogramme C'3 de la figure 4.

Enfin, si la défaillance de la LED a lieu au moment de l'allumage, le circuit 100 va produire deux impulsions de tension en entrée du module 109 «ou exclusif» (cas représenté sur la figure 5) ; dès lors, le module «ou exclusif» ne va pas produire d'impulsion de commande de fermeture des moyens de commutation 110 et on n'aura pas d'impulsion de courant dans la résistance 111. Ce cas est représenté par le chronogramme C'1 de la figure 4.

De la même manière, si une rupture de faisceau se produit, l'entrée 101 ne reçoit pas d'échelon en entrée (bien évidemment l'entrée 102 ne reçoit pas non plus d'échelon puisque le système n'est plus alimenté). Dès lors, en l'absence de génération d'impulsion de tension, les moyens de commutation 110 restent également ouverts. Ce cas est également représenté par le chronogramme C'1 de la figure 4.

Comme nous l'avons déjà expliqué précédemment, en référence à la figure 4, l'absence d'impulsion de courant ne permet donc pas de distinguer une défaillance liée à une rupture de faisceau d'une défaillance liée à une LED.

La figure 6 représente un circuit 200 pour la mise en oeuvre du procédé selon le deuxième mode de réalisation illustré en figure 4 ; ce circuit 200 est une réalisation du circuit 100 de la figure 5 à partir de composants électroniques.

Le circuit 200 comporte :
- deux entrées aptes à recevoir respectivement un signal de puissance et un signal de diagnostic,
- un premier filtre passe-bas RC formé par une résistance R01 et une capacité C01, l'entrée de ce premier filtre passe-bas étant reliée à l'entrée du signal de puissance (ce filtre RC correspond au filtre 103 de la figure 5),
- un second filtre passe-bas RC formé par une résistance R11 et une capacité C11, l'entrée de ce second filtre passe-bas étant reliée à l'entrée du signal de diagnostic (ce filtre RC correspond au filtre 104 de la figure 5),
- un premier filtre passe-haut CR formé par une capacité C02 et une résistance R02, l'entrée de ce premier filtre passe-haut étant reliée à la sortie du premier filtre passe-bas RC (ce filtre CR correspond au filtre 105 de la figure 5),
- un second filtre passe-haut CR formé par une capacité C12 et une résistance R12, l'entrée de ce second filtre passe-haut étant reliée à la sortie du second filtre passe-bas RC (ce filtre CR correspond au filtre 106 de la figure 5),
- deux diodes D01 et D11 ayant chacune son anode reliée respectivement à la sortie du premier filtre passe-haut et à la sortie du second filtre passe-haut (ces diodes sont équivalentes aux diodes 107 et 108 de la figure 5),
- un premier interrupteur M1 du type transistor MOSFET commandé par la cathode commune des diodes D01 et D02,
- un second interrupteur M2 du type transistor MOSFET,
- la source d'alimentation Vbat,
- deux résistances Rd0 et Rd1,
- un troisième et un quatrième interrupteurs M3 et M4 de type transistor MOSFET reliés en série et commandé respectivement par l'anode des diodes D01 et D02,
- une résistance R20.

La résistance Rd0, le premier interrupteur M1, le second interrupteur M2 et la résistance Rd1 sont reliés dans cet ordre en série entre la tension Vbat et la masse.

La résistance R20, le troisième interrupteur M3 et le quatrième interrupteur M4 sont reliés dans cet ordre en série entre la tension Vbat et la masse.

La seconde borne de la résistance R20 (la première étant reliée à la tension Vbat) commande le second interrupteur M2.

Les premier et second interrupteurs M1 et M2 forment les moyens de commutation 110 de la figure 5 et les troisième et quatrième interrupteur M3 et M4 forment le module 109 « ou exclusif » de la figure 5.

Le fonctionnement du circuit 200 est identique à celui du circuit 100 de la figure 5.

Lorsqu'une impulsion attaque le premier interrupteur M1 celui-ci va laisser passer le courant sur la branche composée des résistances Rd0 et Rd1 et va par conséquent générer une surconsommation sous la forme d'une impulsion de courant. Cette surconsommation est toutefois conditionnée par l'état du second interrupteur M2 qui est lui-même dépendant des troisième et quatrième interrupteurs M3 et M4. Pour que le second interrupteur M2 soit passant il faut que l'un au moins des troisième ou quatrième interrupteurs M3 ou M4 soit désactivé (sinon il n'y a pas de commande sur le second interrupteur M2). Les états des troisième et quatrième interrupteurs M3 et M4 sont directement liés aux états des impulsions de tension venant du signal de puissance et du signal de diagnostic. Par conséquent si on a une superposition des deux impulsions de tension, les interrupteurs M3 et M4 seront passants en même temps et vont ainsi désactiver le second interrupteur M2 qui empêchera ainsi la génération d'une surconsommation.

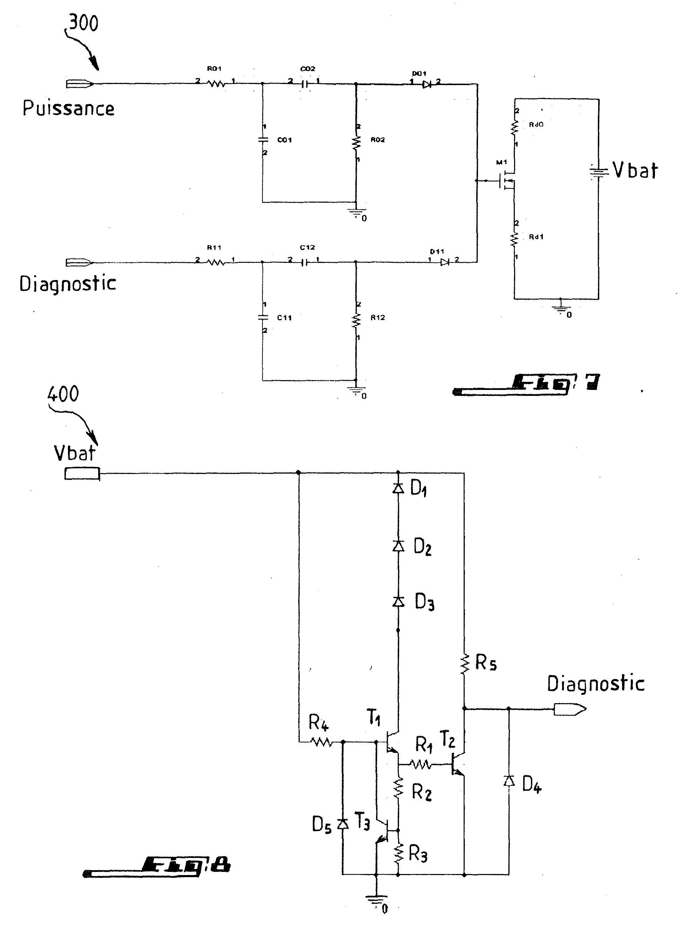

La figure 7 représente un circuit 300 pour la mise en oeuvre du procédé selon le premier mode de réalisation illustré en figure 3.

Ce circuit 300 est identique au circuit 200 (nous avons repris les mêmes références) à la différence qu'il ne comporte pas les composants permettant la réalisation de l'opération « ou exclusif » à savoir :
- les second, troisième et quatrième interrupteurs M2, M3 et M4,
- la résistance R20.

Ce circuit implique qu'il existe un retard entre l'instant de la défaillance du module d'éclairage et le déclenchement de la seconde impulsion pour éviter la superposition de la première et de la seconde impulsion de courant. Ce retard peut être obtenu par exemple en réglant de façon appropriée les valeurs de la résistance R11 et de la capacité C11 de façon à introduire un temps de montée suffisamment long.

Une autre manière de procéder peut constituer à introduire un circuit RC complémentaire en amont de l'entrée de diagnostic, c'est-à-dire au niveau du circuit générant le signal de diagnostic (échelon de tension dont le front montant correspond à la présence d'une défaillance sur au moins une des LEDS).

Un exemple d'un tel circuit 400 est illustré en figure 8. Ce circuit 400 est représenté dans le cas de trois LEDS D1 à D3 montées en série et utilisées dans un module d'éclairage du véhicule.

Ce circuit 400 comporte en outre:
- la source d'alimentation Vbat,
- cinq résistances R1 à R5,
- une diode D5,
- une diode Zener D4,
- trois transistors bipolaires NPN T1 à T3,
- une sortie fournissant le signal de diagnostic mentionné plus haut.

Une première branche est formée par les trois LEDS D1 à D3 montées en série entre la tension Vbat et le collecteur du premier transistor T1, l'émetteur de T1 étant relié en série avec les résistances R2 et R3 et la masse.

Une deuxième branche est formée par la résistance R5 montée en série entre la tension Vbat et le collecteur du second transistor T2, l'émetteur de T2 étant relié à la masse.

Une troisième branche est formée par la résistance R4 montée en série entre la tension Vbat et la cathode de la diode D5 dont l'anode est reliée à la masse.

Une quatrième branche est formée par la borne de connexion de la résistance R4 et de la cathode de la diode D5 reliée à la base du premier transistor T1 et au collecteur du troisième transistor T3, l'émetteur du transistor T3 étant relié à la masse et sa base étant reliée à la borne de connexion des résistances R2 et R3.

La résistance R1 relie l'émetteur du transistor T1 et la base du transistor T2.

La diode Zener D4 est montée en parallèle et en inverse sur le transistor T2.

La sortie de diagnostic est formée par la borne de connexion du collecteur du transistor T2 et de la cathode de la diode Zener D4.

En l'absence de défaillance, le courant circule normalement dans les LEDS D1 à D3 : La présence des transistors T1 et T3 permet d'avoir une tension baseémetteur du transistor T2 suffisante pour rendre le transistor T2 constamment passant. Dès lors, la tension sur la sortie de diagnostic est nulle.

En revanche, si une des LEDS D1 à D3 est défaillante et présente un circuit ouvert, le courant dans la première branche devient nul. Le transistor T1 reste passant et la base du transistor T2 est reliée à la masse. Dès lors, le transistor T2 est bloquant et la tension sur la sortie de diagnostic devient positive : la valeur de la tension de sortie est limitée (par exemple à 5V) par la présence de la diode Zener D4 montée en inverse.

Le circuit 400 permet donc bien de générer une tension de diagnostic en échelon (passage de 0 à 5V) en cas de défaillance sur l'une des LEDS D1 à D3. Ce signal est ensuite injecté sur l'un des circuits 200 ou 300 des figures 6 ou 7. On notera qu'il est possible de rajouter un circuit RC au niveau de la sortie de diagnostic du circuit 400 de façon à introduire un retard.

## Revendications

1. Procédé de détection d'une défaillance sur un système d'alimentation d'une charge électrique d'un véhicule automobile par une source d'alimentation via un réseau électrique **caractérisé en ce que** ladite détection est réalisée suivant les étapes suivantes :
- L'absence de défaillance sur ledit réseau électrique (C2, C'2) est indiquée par l'émission d'une première et unique impulsion (P1) de courant lors de la connexion entre ladite source d'alimentation et ladite charge,
- La présence d'une défaillance localisée sur ledit réseau électrique ou sur ladite charge (C1, C'1) est indiquée par l'absence d'émission de ladite première impulsion de courant lors de la connexion entre ladite source d'alimentation et ladite charge,
- La présence d'une défaillance sur ladite charge survenue après la connexion entre ladite source d'alimentation et ladite charge (C3, C'3) est indiquée par l'émission d'une deuxième impulsion (P3) de courant suivant la première impulsion (P2).

2. Procédé selon la revendication 1 **caractérisé en ce que** ladite charge électrique est une lampe à LED « Light Emitting Diode » (6, 7) et ledit réseau électrique est formé par un faisceau de conducteurs électrique (9).

3. Procédé selon l'une des revendications 1 ou 2 **caractérisé en ce que** la durée des dites première et deuxième impulsions est inférieure ou égale à 200 ms, de préférence de l'ordre de 100 ms.

4. Procédé de détection selon l'une des revendications 1 à 3 **caractérisé en ce que** ladite détection est réalisée suivant les étapes suivantes :
- Ladite absence (C1) d'émission de ladite première impulsion de courant lors de la connexion entre ladite source d'alimentation et ladite charge indique la présence d'une défaillance localisée sur ledit réseau électrique,
- La présence d'une défaillance sur ladite charge est indiquée (C3) par l'émission d'une deuxième impulsion de courant suivant la première impulsion.

5. Circuit (100) pour la mise en oeuvre du procédé selon l'une des revendications 1 à 3 **caractérisé en ce qu'**il comporte :
- une première entrée (101) apte à recevoir un signal d'échelon de tension, dit signal de puissance, correspondant à la tension de mise en connexion entre ladite source d'alimentation et ladite charge,
- une deuxième entrée (102) apte à recevoir un signal d'échelon de tension, dit signal de diagnostic, correspondant à la présence d'une défaillance sur ladite charge électrique,
- des moyens (103, 105, 107) pour transformer ledit signal de puissance en une première impulsion de tension,
- des moyens (104, 106, 108) pour transformer ledit signal de diagnostic en une deuxième impulsion de tension,
- des moyens (109) pour recevoir lesdites première et deuxième impulsions de tension et formant un opérateur « ou exclusif » entre lesdites première et deuxième impulsions,
- des moyens (110) de commutation de courant commandé en tension, la fermeture des moyens de commutation de courant générant lesdites impulsions de courant nécessaires à la détection de défaillance, la présence des dites impulsions de courant étant conditionnées par la sortie dudit opérateur «ou exclusif».

6. Circuit pour la mise en oeuvre du procédé selon la revendication 4 **caractérisé en ce qu'**il comporte :
- une première entré apte à recevoir un signal d'échelon de tension, dit signal de puissance, correspondant à la tension de mise en connexion entre ladite source d'alimentation et ladite charge,
- une deuxième entrée apte à recevoir un signal d'échelon de tension, dit signal de diagnostic, correspondant à la présence d'une défaillance sur ladite charge électrique,
- des moyens pour transformer ledit signal de puissance en une première impulsion de tension,
- des moyens pour transformer ledit signal de diagnostic en une deuxième impulsion de tension,
- des moyens de commutation de courant commandé par lesdites première et deuxième impulsions de courant, la fermeture dudit interrupteur de courant générant lesdites impulsions de courant nécessaires à la détection de défaillance,
- des moyens pour empêcher une superposition des dites première et deuxième impulsions de courant.

7. Circuit selon la revendication précédente **caractérisé en ce que** lesdits moyens pour empêcher une superposition des dites première et deuxième impulsions sont formés par un circuit RC.

8. Circuit (200, 300) selon l'une des revendications 5 à 7 **caractérisé en ce que :**
- lesdits moyens pour transformer ledit signal de puissance en une première impulsion de tension comportent un premier filtre passe bas RC (R01, C01), un premier filtre passe haut CR (C02, R02) et une première diode (D01),
- lesdits moyens pour transformer ledit signal de diagnostic en une seconde impulsion de tension comportent un second filtre passe bas RC (R11, C11), un second filtre passe haut CR (C12, R12) et une seconde diode (D11).

9. Circuit (200) selon les revendications 5 et 8 **caractérisé en ce que :**
- lesdits moyens de commutation de courant comportent un premier (M1) et un second (M2) interrupteur de courant reliés en série avec au moins une résistance (Rd0,Rd1) et une source d'alimentation (Vbat), ledit premier interrupteur (M1) étant commandé par la cathode commune des dites première et seconde diodes (D01, D02).
- lesdits moyens pour recevoir lesdites première et deuxième impulsions de tension et formant un opérateur « ou exclusif » entre lesdites première et deuxième impulsions comportent:
○ un troisième interrupteur (M3) commandé par la sortie dudit premier filtre passe haut CR (C02, R02),
○ un quatrième interrupteur (M4) commandé par la sortie dudit second filtre passe haut CR (C12, R12),
Lesdits second, troisième et quatrième interrupteurs (M2, M3, M4) de courant étant agencés de sorte que l'ouverture desdits troisième ou quatrième interrupteurs (M3, M4) de courant entraîne la fermeture dudit deuxième interrupteur (M2) de courant.

10. Circuit selon l'une des revendications 5 à 9 **caractérisé en ce qu'**au moins un desdits premier à quatrième interrupteurs est un transistor MOSFET.
